# EUROPEAN PATENT APPLICATION

(11) **EP 3 196 012 A1**
(43) Date of publication of application: **26.07.2017**
(21) Application number: 16151996.2
(22) Date of filing: 20.01.2016
(51) Int. Cl.: B32B 17/10, H01L 31/048

(54) **ORGANIC PHOTOVOLTAIC ASSEMBLY AND PROCESS OF MANUFACTURE**

(71) Applicant: AGC Glass Europe, 1348 Louvain-la-Neuve (BE); Heliatek GmbH, 01139 Dresden (DE); Asahi Glass Company, Limited, Chiyoda-ku Tokyo 100-8405 (JP); AGC Glass Company North America, Alpharetta GA 30022-1167 (US)
(72) Inventor: DEMEYERE, Michaël, 5380 Forville (BE); POOT, Benoit, 5030 Gembloux (BE); GUTTOWSKI, Aron, 01097 Dresden (DE); HERMENAU, Martin, 0175 Freital (DE)
(74) Representative: Chabou, Samia

(57) **Abstract**

An organic photovoltaic assembly 1 comprising a first glass layer 2, a layer comprising an organic photovoltaic component 4, at least one interlayer of copolymer Ethylene Vinyl Acetate (EVA) 3 or 5 or 7 and a substrate 6.

## Description

### Technical domain of the invention

The field of the present invention relates to buildings or land vehicles for housing people or transporting people, or any other element such as street furniture, noise barriers, greenhouses, balustrades, louvers or double skin glasses, which comprise glazing panels with an organic photovoltaic device comprising an interlayer made of an Ethylene Vinyl Acetate copolymer (EVA) and to the process for obtaining the assembly.

### Background of the invention

Photovoltaic (PV) modules and cells based on inorganic wafers are well known. PV modules based on thin film modules, rather than on wafers have also been developed.

On the other hand, organic photovoltaic modules and cells have been published. Usually organic photovoltaic devices comprise at least two electrodes, and at least one photoactive layer and optionally various other doped and/or un-doped layers between the electrodes. The other layers have different functions, for instance carrier transport, blocking or passivation layers. The photoactive layers of some published photoactive components comprise layers with small molecules. These photoactive layers are often formed as mixed layers for getting highly efficient devices. In the context of the present invention, small molecules are understood to be non-polymeric organic molecules having monodisperse molar masses of between 100 and 2000. In particular, these small molecules can also be photoactive, wherein photoactive is understood to mean that the molecules change their charge state under light incidence (WO 2004 083 958 A2, WO 2006 092 134 A1, WO 2011161 108 A1) where the quantum efficiency of the charge transfer process is enhanced by electric fields and appropriate heterojunctions between donor-type and acceptor-type molecules.

WO 2009 151 952 A2 discloses a thin film PV module comprising a base substrate, a thin film PV device in contact with the base substrate, a poly(vinyl butyral) layer (PVB) disposed in contact with the PV device and a protective substrate.

Beside PV, WO 2014 083 110 A1 discloses a similar stack of an organic LED assembly, comprising two glasses, an interlayer, which can be made of EVA, and an organic light emitting diode.

Despite the efforts made to have well sealed PV modules, water diffusion to the functional film is a big challenge specifically associated with organic PV in that water will degrade the functional molecules and its electrode interfaces. In addition, depending on their nature, associated polymers or their constituting monomers used for lamination processes may react with organic PV molecules, which will thus reduce the efficiency or the lifetime.

Several reports, e.g. Hülsmann et al. (2009), "Measuring temperature-dependent water vapour and gas permeation through high barrier films" Review of Scientific Instruments, 80, 113901 and Peike et al. (2012) "Impact of Permeation properties and backsheet-encapsulant interactions on the reliability of PV modules" International Scholarly Research Network, Volume 2012, Article ID 459731, have shown that EVA polymer is not a good candidate as it shows a high water vapour penetration rate, and thus devices encapsulated using EVA show poor results in damp heat tests.

Thus, the Applicant has discovered that water diffusion is a problem for organic PV.

On the other hand, EVA - in contrast to other polymers - is not a good barrier for water.

Hence, one should conclude that EVA should not be incorporated into organic PV assemblies.

### Technical Problem

In other words, there is the need to develop organic PV modules but - according to the literature cited above - the development of organic PV should be based on interlayers selected for their capacity of blocking water diffusion, thereby stabilizing the functional film and EVA should not be used for this purpose.

To this end, and to the contrary to these assumptions, the Applicant submits his invention, which is an assembly comprising a first glass layer, a film comprising an organic photovoltaic (PV) component, and at least one layer of copolymer Ethylene Vinyl Acetate (EVA) and a substrate.

The Applicant has measured that EVA, despite being reactive during the lamination process to obtain the assembly, has not damaged the organic photovoltaic (PV) component or organic photovoltaic stack. The rationale approach was to select polymers for their capacity to block water diffusion, then to select the organic PV stacks for their performances.

The Applicant has found that this approach is not valid in the present case.

It is after a quite long trial-and-error process that the applicant succeeded in defining the above claimed assembly. This process has really not been straight forward and it should be recognized that the above features of the claimed assembly are interrelated in a complex manner which cannot be easily explained. Preferably, the film comprising the organic photovoltaic component is placed between two layers of EVA thermoplastic interlayer.

In one embodiment, the film comprising the organic photovoltaic component comprises photoactive layers with small molecules. In another preferred embodiment, the organic photovoltaic component is a flexible film.

In one embodiment, the second substrate is a glass.

### Brief description of figures

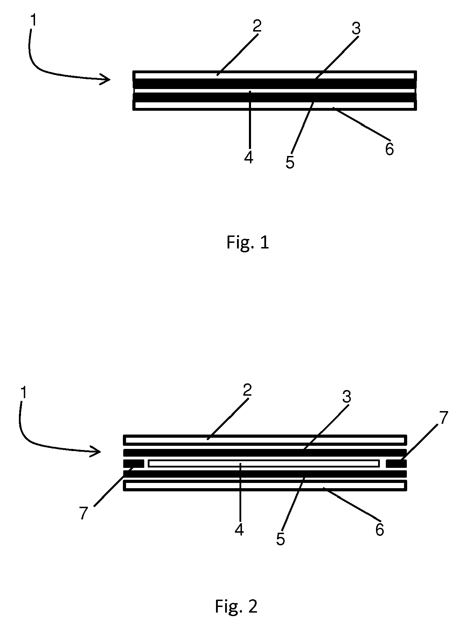

Figures 1 and 2 are a cross-sectional view of the assembly of the present invention.

### Detailed description of the invention

The Applicant has successfully developed an assembly 1 comprising a functional film including an organic photovoltaic (PV) component 4, based on polymers or organic small molecules as an alternative to inorganic PV cells made of silicon wafers, amorphous or microcrystalline silicon thin films or any other inorganic PV technology.

The Applicant suggests an assembly 1 comprising a first glass module 2, a functional film of an photovoltaic component 4 preferred with organic molecules , at least one interlayer of Ethylene Vinyl Acetate copolymer 3, 5, or 7 and a substrate 6.

The first problem has been to select an interlayer 3 and/or 5 that will not react with the photovoltaic (PV) organic component 4 resulting in reduced functionalities. On the other hand, the environment causes heating of the assembly, heat variation, light radiation and water diffusion inside the assembly. All these conditions markedly affect the organic photovoltaic component, especially with small molecules, and there is the need to select interlayers 3 and/or 5 for the capacity to protect the organic PV component 4, especially against water diffusion.

The organic PV component 4 may be a single, tandem, triple or multiple organic PC component.

### Example 1 Chemical compatibility between organic PV and the interlayer

The Applicant has thus firstly selected materials to be constitutive of the interlayers 3 and/or 5 made of PVB, PU and ionomer as they were shown to allow lower water vapour transmission rates.

The material to test is directly placed on the stack comprising organic PV component and placed on a heating plate. After a given time period at a given temperature, there is the observation for any colour change of the organic stack comprising the organic PV molecule. An absence of color change means the tested material is not reacting with the organic stack comprising the organic PV molecule. On the contrary, if the colour changes, both products (organic PV and polymer interlayer) are reacting and the material must be rejected as interlayer and/or encapsulation film.

To be as representative as possible, the materials to be constitutive of the interlayers 3 and/or 5 were previously processed and then removed from the laminated glass. Indeed, this has permitted to have the same chemistry as the final product since the inventors have noticed that ionomers are reacting during the lamination process, which modifies the properties of these materials.

The Applicant has thus tested stacks with different types of PVB and ionomers, as well as polyurethanes (PU) in the interlayer.

The Applicant has firstly used mild conditions in an attempt to identify all the molecules that would be suitable. The test temperature has been fixed at 80°C and the duration at 5 minutes. The results are shown at Table 1.

**Table 1: heating of a stack comprising a film with organic photovoltaic component 4 with polymer interlayers 3 at 80°C for 5 min.**

| Material | PVB | | | | | | | Ionomer | | PU |
|---|---|---|---|---|---|---|---|---|---|---|
| | PVB 1 | PVB 2 | PVB 3 | PVB 4 | PVB 5 | PVB 6 | PVB 7 | ION. 1 | ION. 2 | PU 1 |
| Avg. Area with color change [%] | 93 | 91 | 93 | 89 | 89 | 91 | 89 | 18 | 11 | 78 |

When running tests on this basis, the Applicant has noticed major changes of colours, especially for PVB materials (all of them, even under mild conditions).

From these results, both types of ionomers appear to be suitable and, surprisingly, PVB and PU are not suitable as interlayer material.

Then the Applicant performed the same test under the more stringent conditions, where the organic stack with the interlayer material to be tested is heated at 120°C during 5 minutes, and the results are shown at Table 2.

**Table 2: heating of stack comprising a film with organic photovoltaic component 4 with polymer interlayer 3 at 120°C for 5 min.**

| Material | PVB | | | | | | | Ionomer | | PU |
|---|---|---|---|---|---|---|---|---|---|---|
| | PVB 1 | PVB 2 | PVB 3 | PVB 4 | PVB 5 | PVB 6 | PVB 7 | ION. 1 | ION. 2 | PU 1 |
| Avg. Area with color change [%] | 100 | 100 | 100 | 100 | 100 | 100 | 100 | 88 | 100 | 94 |

Surprisingly, the ionomers are now considered as not acceptable as interlayer for organic PV.

Then the Applicant has tested three different types of EVA polymers, despite their higher water permeability.

Exactly as for the other polymers, the test temperature has been firstly fixed at 80°C and the duration at 5 minutes, and the results are shown at Table 3.

**Table 3: heating of stack comprising a film with organic photovoltaic component 4 with EVA interlayer 3 at 80°C for 5 min.**

| Material | EVA | | |
|---|---|---|---|
| | EVA 1 | EVA 2 | EVA 3 |
| Avg. Area with color change [%] | 5 | 5 | 3 |

At these mild conditions, the EVA molecules did not affect the PV stack.

Then, exactly as for the other polymers, the Applicant has fixed the test conditions at 120°C and the results are shown at Table 4.

**Table 4: heating of stack comprising a film with organic photovoltaic component 4 with EVA interlayer 3 at 120°C for 5 min.**

| Material | EVA | | |
|---|---|---|---|
| | EVA 1 | EVA 2 | EVA 3 |
| Avg. Area with color change [%] | 36 | 4 | 18 |

EVA as a whole shows more limited degradation than the other polymers shown in Table 2.

This more stringent test furthermore shows differences between the EVA materials for interlayers.

### Example 2 Incorporation of the organic PV and of the EVA interlayer in a PV assembly according to the invention

The assembly 1 comprises a first glass module 2, a functional film of an photovoltaic component 4 with organic small molecules , at least one interlayer of Ethylene Vinyl Acetate copolymer 3, 5, or 7 and a substrate 6.

One or more films 3 of EVA are applied on a first substrate 2. In the tests, the first substrate 2 is a transparent glass with less than 0.02 wt% of iron in the form of Fe2O3.

A layer comprising the organic PV component 4 is then added and the electric connections are put. Optionally, a compensation layer of interlayer 7 can be added on the surroundings of the layer with the PV component to obtain a better aesthetical result, for instance without bubbles, as shown in figure 2.

One or more films of EVA 5 are added on this stack. Optionally, the layer comprising the organic PV component is surrounded by a further frame of a film of EVA thermoplastic interlayer. The one or more films of EVA may have a thickness between 0.2 to 1.5 mm and preferably between 0.2 to 1.2 mm.

The use of ethylene vinyl acetate copolymer (EVA) as thermoplastic interlayer film allow to decrease the temperature used during the lamination process and allows to prevent the degradation of the film comprising the organic PV component. In parallel there is no need of high pressure (autoclave) thanks to utilization of this kind of interlayer.

A second substrate (herein glass) 6 is placed. The second substrate glass may be a lacquered glass for an aesthetic aspect.

According to the present invention, the substrate may be any rigid structure, including plastic or glass. Preferably, the substrate is a glass substrate. The glass substrate used may be flat glass, in particular float glass of various thicknesses; it may be soda lime glass and may be clear, extra-clear, coloured, etched, sand-blasted, patterned or coated glass, or particular compositions for display applications. The glass may be bent. Glass sheets according to the invention may have a size greater than 1m x 1m. They may have various sizes depending on the desired application.

A preferred front glass is a low-absorbing (low iron) glass.

According to another embodiment of the present invention, the glass substrate is a heat treated glass sheet, for example annealed or tempered and/or bended glass sheet. Typically, this involves heating the glass sheet (coated or not) in a furnace to a temperature of at least 580°C, more preferably of at least about 600°C and still more preferably of at least 620°C before rapidly cooling down the glass substrate. This tempering and/or bending can take place for a period of at least 4 minutes, at least 5 minutes, or more in different situations.

The glass may be coated with an anti-reflective coating, an anti-scratch coating.

This assembly 1 is tightly fixed and placed in a device able to apply low pressures and high temperatures, submitted to a degassing step under reduced pressures (typically below 0.35-0.15 bar) for at least 30 minutes, and then to temperatures of at least 95°C for at least 45 min.

The vacuum has been removed at the same high temperatures for more than 3 hours, then the temperature is reduced and the assembly is removed from the device.

Given the high temperatures, EVA is liquid, which forces to tightly fix the layers.

The obtained assembly displays good PV properties.

### Example 3 Incorporation of the organic PV component and of the EVA monomers in a PV assembly

The assembly 1 comprises a first glass module 2, a functional film of an photovoltaic component 4 with organic small molecules , at least one interlayer of Ethylene Vinyl Acetate copolymer 3, 5, or 7 and a substrate 6. A first film 3 of non-polymerized EVA is applied on a first substrate 2, preferably a transparent glass with less than 0.02 wt% of iron in the form of Fe2O3.

A layer comprising the organic photovoltaic component 4 is then added and the electric connections are put. Preferably, the organic PV component is flexible and/or comprises small organic molecules in the photoactive layers. Eventually, a compensation layer of interlayer 7 can be added to obtain a better aesthetical result.

A second film of non-polymerized EVA 5 is added on this stack.

A second substrate (herein glass) 6 is placed.

This assembly 1 is tightly fixed and placed in a device able to apply low pressures and high temperature. The cycle starts with a degassing step under reduced pressures, typically below 0.35 to 0.15 bar. The temperature is then increased to around 90°C in order to reach the maximum fluidity of the EVA to fill all the cavities in the assembly. After a given time, the temperature is increased up to 120°C to polymerize the EVA. This temperature is a good compromise between the polymerization reaction and the organic stability, which cannot sustain a temperature higher than 120°C.

Finally, the temperature is reduced, the vacuum is removed and the assembly is removed from the device.

The obtained assembly displays good PV properties.

## Claims

1. An organic photovoltaic assembly (1) comprising a first glass layer (2), a film comprising a organic photoactive component (4), at least one interlayer of Ethylene Vinyl Acetate copolymer (3) or (5) or (7) and a substrate (6).

2. The assembly (1) of claim 1, wherein the substrate (6) is a glass.

3. The assembly (1) of claim 1 or 2, wherein the first glass layer (2) is transparent glass, preferably with less than 0.02 wt% of iron expressed in the form of Fe₂O₃.

4. The assembly (1) according to any one of the preceding claims, comprising at least two layers of copolymer Ethylene Vinyl Acetate (3) and (5) encapsulating the film comprising the organic photoactive component (4).

5. The assembly (1) according to any of the preceding claims, wherein the film comprising the organic photoactive component (4) is flexible.

6. The assembly according to any one of the preceding claims wherein the organic photovoltaic component is an organic photoactive component comprising small molecules in at least one of the photoactive layers.

7. A process for the production of an organic photovoltaic assembly (1) comprising the steps of:
- adding a composition comprising at least one EVA layer on a glass substrate (2);
- adding a film comprising organic photoactive component (4);
- adding a second substrate (6) and tightly fixing the obtained stack;
- laminating the at least one EVA layer in the said stack so as to form an EVA polymer interlayer (3) or (5) laminating the said organic photoactive component (4).

8. The process of claim 7 wherein at least one EVA layer is added between the PV film (4) and the second substrate (6).

9. The process of claim 7 or 8 wherein at least one EVA compensation layer is added on the surroundings of the PV film (4).

10. The assembly obtainable by the process of any one of the claims 7 to9.
